# EUROPEAN PATENT SPECIFICATION

(11) **EP 3 754 826 B1**
(45) Date of publication and mention of the grant of the patent: **16.11.2022**
(21) Application number: 19181606.5
(22) Date of filing: 21.06.2019
(51) Int. Cl.: H02M 1/08, H02M 3/338, H02M 3/00, H02M 1/00, H03K 17/284

(54) **OPERATING DEVICE FOR AN ILLUMINANT**
BETRIEBSVORRICHTUNG FÜR EIN LEUCHTMITTEL
DISPOSITIF DE FONCTIONNEMENT D'UN ÉCLAIRAGE

(43) Date of publication of application: 23.12.2020
(73) Proprietor: Tridonic GmbH & Co. KG, 6851 Dornbirn (AT)
(72) Inventor: Saccavini, Lukas, 6850 Dornbirn (AT)
(74) Representative: Beder, Jens

(56) References cited:
- US-A- 4 605 999
- US-A1- 2012 249 189
- US-A1- 2015 349 627
- US-A1- 2018 331 613
- EFREN FLORES-GARCIA ET AL: "Analysis and design method for high frequency self-oscillating electronic ballasts", ENERGY CONVERSION CONGRESS AND EXPOSITION (ECCE), 2010 IEEE, IEEE, PISCATAWAY, NJ, USA, 12 September 2010 (2010-09-12), pages 1343-1346, XP031787482, ISBN: 978-1-4244-5286-6
- MADSEN MICKEY P ET AL: "Very high frequency half bridge DC/DC converter", 2014 IEEE APPLIED POWER ELECTRONICS CONFERENCE AND EXPOSITION - APEC 2014, IEEE, 16 March 2014 (2014-03-16), pages 1409-1414, XP032590963, DOI: 10.1109/APEC.2014.6803491 [retrieved on 2014-04-21]

## Description

The invention relates to an operating device for an illuminant and a method for controlling the operating device. More specifically, the invention relates to an operating device and method, in which a control signal for switching the transistor of a DC-to-DC converter is generated based on a LC circuit.

Switched mode DC-to-DC converters are often used to provide power for LED arrays and other appliances requiring low-level direct current (DC) power. In the converter of an operating device, input DC power is chopped by a switching circuit and fed into an energy storage device, usually an inductor, wherein energy from the chopped DC power is alternately stored into a magnetic field and discharged therefrom into a secondary circuit containing a capacitor to produce a conditioned DC output voltage.

The size of the inductor and the converter can be reduced by increasing the switching frequency. In some converters, an LC circuit is used to generate a control signal for switching a transistor connected to the inductor with a high frequency. However, with such self-oscillating circuit, it is difficult to change the switching frequency, so that the output power can not be varied or must be controlled by varying the DC input voltage of the converter.

A resonant converter to drive a LED, where the gate-voltage of the switches is generated by a self-oscillating arrangement with an LC circuit is disclosed in the Article with title: "Very high frequency half bridge DC/DC converter" from Madsen Mickey P et al.

It is an object of the present invention to provide an operating device for an illuminant and a method for controlling an operating device, with which the switching frequency can be varied with low effort and costs.

An operating device and a method according to the enclosed independent claims achieve this object. Advantageous features of the present invention are defined in the corresponding dependent claims.

According to the present invention, the operating device for an illuminant comprises a voltage converter having at least one transistor controlled by a control signal, an LC circuit for generating the control signal having at least a first capacitor and a second capacitor, at least one switch for connecting the first capacitor or the second capacitor to the LC circuit, and a control means for controlling the switch to change the switching frequency of the transistor. In this way, the switching frequency can easily be modified by changing the capacitance of the LC circuit.

The voltage converter is a LLC resonant converter comprising at least one half bridge including a first transistor and a second transistor. The LC circuit comprises a first resonant circuit for generating the control signal for the first transistor and a second resonant circuit for generating the control signal for the second transistor, wherein each of the first resonant circuit and the second resonant circuit comprises at least the first capacitor and the second capacitor. The operating device comprises at least a first switch for connecting the first capacitor or the first and the second capacitor of the first resonant circuit to the first resonant circuit and at least a second switch for connecting the first capacitor or the first and the second capacitor of the second resonant circuit to the second resonant circuit.The control means is configured to control the first switch to change the switching frequency of the first transistor and to control the second switch to change the switching frequency of the second transistor.

In order to provide a plurality of self-oscillating frequencies, each resonant circuit can comprise a plurality of capacitors connectable in parallel to each other by a plurality of switches, wherein the control means is configured to control the plurality of switches to change the switching frequency of the transistor.

The capacitors may have the same values or different values, so that there is a variety of different combinations of capacities.

In addition, the LLC resonant converter can comprise a plurality of half bridges, wherein each half bridge comprises the first transistor and the second transistor and is connected to the LLC resonant circuit by a separate capacitor.

The switches of all half bridges can be controlled by the control means. Alternatively, for every half bridge or a part of the half bridges separate control means is provided.

Alternatively or in addition, the voltage converter can be configured to convert a DC voltage into a working voltage for the illuminant.

According to the present invention, the method for controlling an operating device as described above comprises the step of controlling the switches to change the switching frequency of the transistors.

The invention is explained below in more detail with reference to the attached drawings, in which:
FIG. 1 shows, in schematic form, a first embodiment of the operating device according to the present invention;
FIG. 2 shows, in schematic form, a second embodiment of the operating device according to the present invention;
FIG. 3 shows, in schematic form, a third embodiment of the operating device according to the present invention; and
FIG. 4 shows a flowchart of the method according to an embodiment of the present invention.

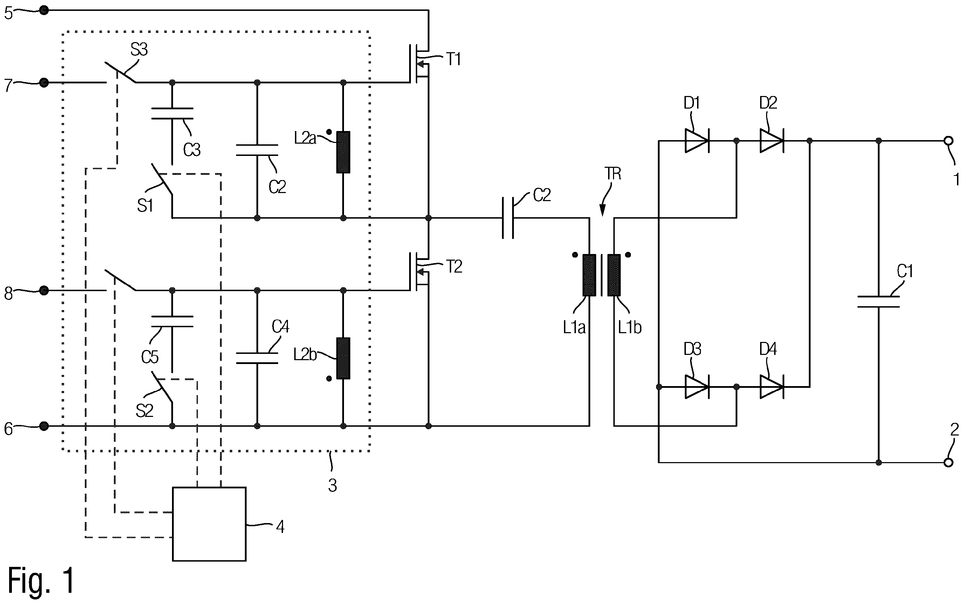

In figures 1 to 4, same reference signs refer to the same or corresponding elements.

FIG. 1 shows an LLC converter section of the operating device for an illuminant according to the present invention. The operating device is used to generate an operation voltage for the illuminant, which can include one or several light-emitting diodes (LED), and comprises a rectifier for rectifying an input AC voltage to a DC voltage (not shown) and the LLC converter for converting the DC voltage output by the rectifier into a working voltage for the illuminant.

The LLC converter, which is represented in FIG. 1 in a simplified manner, comprises a switching bridge (half bridge) including two serially connected transistors T1, T2, a transformer TR, a bridge rectifier D1..D4 connected to a secondary winding L1a of the transformer TR, an output capacitor C1 connected to the bridge rectifier D1..D4, output terminals 1, 2 for connecting the illuminant, an LC circuit 3 for generating switching signals for the transistors T1, T2, a control means 4 for controlling the LC circuit 3 and an LLC resonant circuit connected to the mid-point of the switching bridge and formed by a capacitor C2 und a primary winding L1b of the transformer TR (the series resonant inductance and the transformer's magnetizing inductance). The transistors T1, T2 can be field-effect transistors or metal-oxide-semiconductor field-effect transistors (MOSFET).

The switching bridge is connected to input terminals 5, 6, at which the DC voltage output by the rectifier is supplied, and generates a square waveform to excite the LLC resonant circuit, which will output a resonant sinusoidal current that gets scaled by the transformer TR and rectified by the bridge rectifier D1..D4. The output capacitor C1 filters the rectified AC current.

Control means 4 controls LC circuit 3 to generate control signals for switching the transistors T1 and T2 alternatingly. This may involve the detection and evaluation of signals indicating the voltage and/or current supplied to the output terminals 1, 2. The control means 4 can be a microcontroller or an Application-Specific Integrated Circuit (ASIC), which controls all components of the operating device or merely control the switching times of the transistors T1 and T2 based on a control signal of a main controller.

The LC circuit 3 comprises a first resonant circuit formed by an inductor L2a connected in parallel to the gate terminal and the source terminal of the transistor T1, a capacitor C2 connected in parallel to the inductor L2a, a capacitor C3 connectable in parallel to the capacitor C2 by a switch S1 and a second resonant circuit formed by an inductor L2b connected in parallel to the gate terminal and the source terminal of the transistor T3, a capacitor C4 connected in parallel to the inductor L2b, a capacitor C5 connectable in parallel to the capacitor C4 by a switch S2. Switches S3 and S4 connect the first resonant circuit and the second resonant circuit to voltage terminals 7 and 8 (supply voltage, e.g. 12 V) to excite the first resonant circuit and the second resonant circuit, respectively.

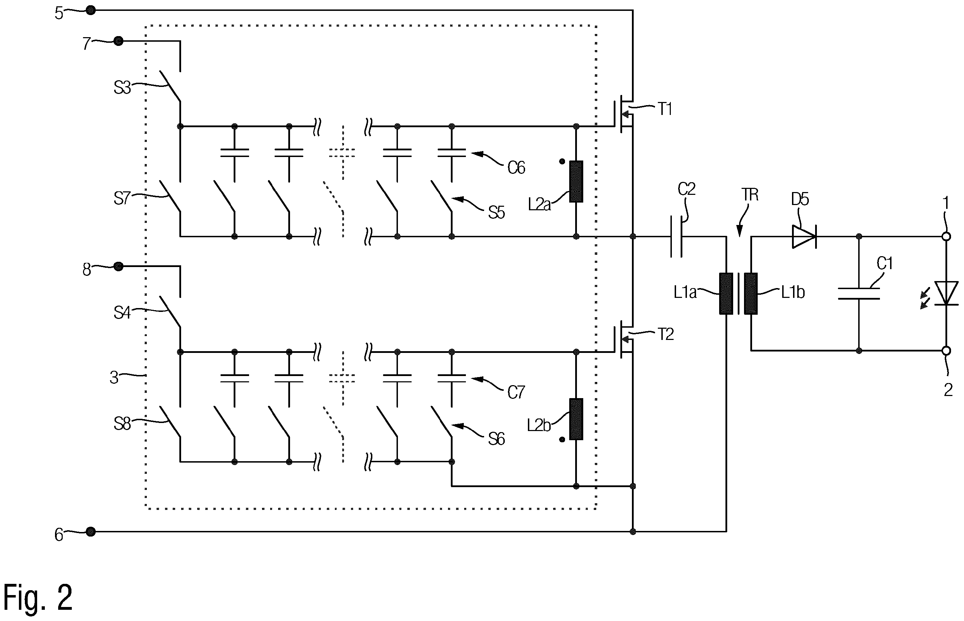

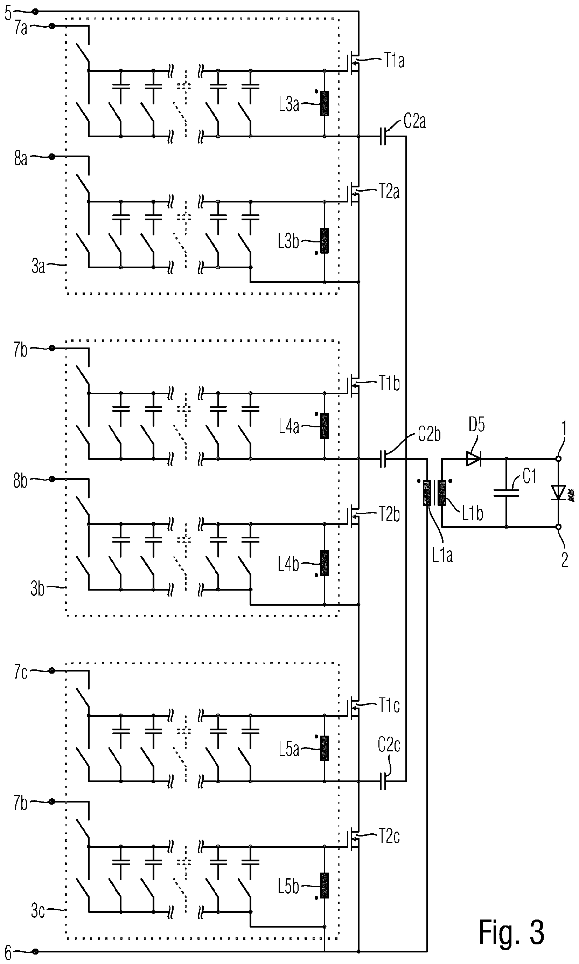

In the LC circuit 3 shown in FIG. 1, the inductors L2a and L2b are magnetically coupled and form of a transformer having windings (L2a and L2b) wound in opposite directions, so that the first resonant circuit and the second resonant circuit are coupled, wherein the self-oscillating frequency is a result of the inductance of L2a/L2b and the gate source capacitance. Alternatively, the inductors L2a and L2b can have no magnetic connection to each other. This also applies to the second and third embodiment of the operating device shown in FIG. 2 and FIG. 3, respectively.

The self-oscillating frequency of the first resonant circuit and the self-oscillating frequency of the second resonant circuit are varied by switching the switches S1 and S2, respectively, wherein the control means 4 controls the switches S1..S4 in order to vary the switching times of the transistors T1, T2 to increase or reduce the output power of the operating device. The output power can be adjusted to a dimming signal and/or a load change, which is detected by the control means 4 or is indicated by a received signal.

The capacity of the capacitors C2..C5 and the inductance of the inductors L2a..L2b depend on desired self-oscillating frequencies, wherein the capacitors C2 and C4, the capacitors C3 and C5 and the inductors L2a and L2b are identical and the capacitors C2 and C3 and the capacitors C4 and C5 can be different.

FIG. 2 shows a second embodiment of the operating device according to the present invention, in which each of the first resonant circuit and the second resonant circuit comprises five or more capacitors C5, C7 connectable in parallel to each other by switches S5, S6 and a switch S7, S8, with which the capacitors C5, C7 and the inductors L2a..L2b can be bypassed/short-circuited. The switches S3..S8 are controlled by the control means 4 (not shown) in order to vary the switching times of the transistors T1, T2. It is to be noted that fewer capacitors may also be provided.

With the plurality of capacitors C5, C7, the range, in which the self-oscillating frequency can be changed, is increased. Alternatively or in addition, the self-oscillating frequency can be changed in small steps, so that a difference between the self-oscillating frequency of the first resonant circuit and the self-oscillating frequency of the second resonant circuit resulting from component tolerances can be compensated. For this, control means 4 detects this difference and increases or reduces the capacitance in the first resonant circuit and/or the second resonant circuit by connecting/disconnecting one or more capacitors C5, C7 in order to reduce the difference to a possible minimum.

Alternatively, the manufacturer determines the difference, and based thereon a table, which assigns to each possible self-oscillating frequency or output power a switch setting of the switches S5, S6, is generated and is stored in the operating device, wherein the control means 4 controls the LC circuit 3 based on the stored table.

FIG. 3 shows a third embodiment of the operating device according to the present invention, in which three half bridges connected in series are connected to the input terminals 5, 6, so that the voltage is distributed among the three half bridges to reduce the stress on a single transistor. The LLC resonant circuit is formed by the primary winding L1b and three capacitors C2a, C2b, C2c connected in parallel to each other, wherein each capacitor C2a, C2b, C2c is connected to the mid-point of one of the switching bridges and each half bridge contains a LC circuit 3a, 3b, 3c that corresponds to the LC circuit 3 shown in FIG. 2.

The control means 4 (not shown) controls the LC circuits 3a, 3b, 3c to generate control signals for switching the transistors T1a..T2c and to vary the self-oscillating frequency as described above, wherein the transistors T1a, T1b, T1c are switched on and the transistor T2a, T2b, T2c are switched off and after a certain dead time the transistor T1a, T1b, T1c are switched off and the transistors T2a, T2b, T2c are switched on. Alternatively, each half bridge can be controlled by a separate control means 4 (driver IC).

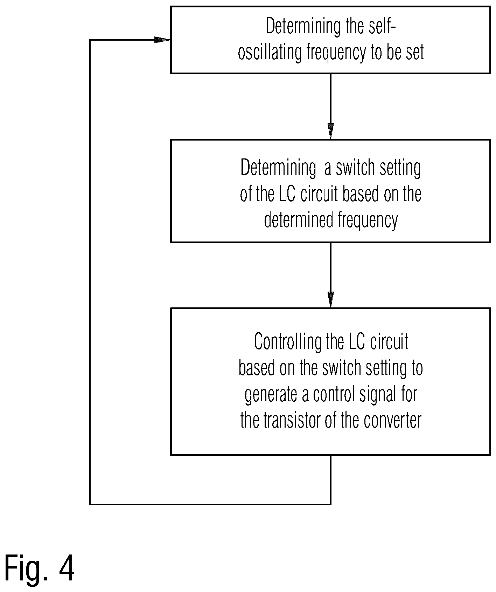

FIG. 4 shows a very simplistic flowchart showing the single steps performed by the method described in detail above.

## Claims

1. An operating device for an illuminant comprising
a LLC resonant converter including a LLC resonant circuit and at least one half bridge including a first transistor (T1) and a second transistor (T2), wherein each transistor is configured to be controlled by a control signal; and
a LC circuit (3) arranged to generate the control signal, wherein the LC circuit (3) comprises a first resonant circuit arranged to generate the control signal for the first transistor (T₁) and a second resonant circuit arranged to generate the control signal for the second transistor (T2), wherein each of the first resonant circuit and the second resonant circuit comprises at least an inductor (L2a, L2b), a first capacitor (C2, C4) and a second capacitor (C3, C5), and
the operating device comprises
- a first switch (S1) for connecting the first capacitor (C2) in parallel with the second capacitor (C3) of the first resonant circuit,
- a second switch (S2) for connecting the first capacitor (C4) in parallel with the second capacitor (C5) of the second resonant circuit, and control means (4) configured to control the first switch (S1) to change the capacitance of the first resonant circuit and as a result the switching frequency of the first transistor and to control the second switch (S2) to change the capacitance of the second resonant circuit and as a result the switching frequency of the second transistor (T2).

2. The operating device according to claim 1, wherein
each of the first resonant circuit and the second resonant circuit comprises a plurality of capacitors (C6; C7) connectable in parallel to each other by a plurality of switches (S5; S6), and
the control means (4) is configured to control the plurality of switches (S5; S6) to change the capacitance of the corresponding resonant circuit and as a result
the switching frequency of the at least one transistor (T1; T2).

3. The operating device according to anyone of the preceding claims, wherein
capacitances of the capacitors (C6; C7) are different.

4. The operating device according to anyone of the preceding claims, wherein
the LLC resonant converter comprises a plurality of half bridges, wherein each half bridge comprises the first transistor (T1) and the second transistor (T2) and is connected to the LLC resonant circuit by a separate capacitor (C2a, C2b, C2c).

5. The operating device according to claim 4, wherein
the control means (4) is configured to control each switch (Sia..Sic, S2a..S2c) of the plurality of half bridges.

6. The operating device according to anyone of the preceding claims, wherein
the voltage converter is configured to convert a DC voltage into a working voltage for the illuminant.

7. A method for controlling an operating device for an illuminant according to claim 1, the method comprising the steps of:
generating, by the first resonant circuit of the LC circuit (3), the control signal for the first transistor (T1) and, by the second resonant circuit of the LC circuit (3), the control signal for the second transistor (T2),
controlling the first switch (S1) connecting the first capacitor (C2) in parallel with the second capacitor (C3) of the first resonant circuit change capacitance of the first resonant circuit and as a result the switching frequency of the first transistor, and
controlling the second switch (S2) connecting the first capacitor (C4) in parallel with the second capacitor (C5) of the second resonant circuit to change the capacitance of the second resonant circuit and as a result to change the switching frequency of the second transistor (T2).

## Patentansprüche

1. Betriebsvorrichtung für ein Leuchtmittel, umfassend
einen LLC-Resonanzwandler, einschließlich eines LLC-Resonanzkreises und mindestens eine Halbbrücke, einschließlich eines ersten Transistors (T1) und eines zweiten Transistors (T2), wobei jeder Transistor konfiguriert ist, um durch ein Steuersignal gesteuert zu werden;
und
eine LC-Schaltung (3), die angeordnet ist, um das Steuersignal zu erzeugen, wobei
die LC-Schaltung (3) einen ersten Resonanzkreis, der angeordnet ist, um das Steuersignal für den ersten Transistor (T1) zu erzeugen, und einen zweiten Resonanzkreis umfasst, der angeordnet ist, um das Steuersignal für den zweiten Transistor (T2) zu erzeugen, wobei jeder des ersten Resonanzkreises und des zweiten Resonanzkreises mindestens einen Induktor (L2a, L2b), einen ersten Kondensator (C2, C4) und einen zweiten Kondensator (C3, C5) umfasst, und
die Betriebsvorrichtung umfasst
- einen ersten Schalter (S1) zum parallelen Verbinden des ersten Kondensators (C2) mit dem zweiten Kondensator (C3) des ersten Resonanzkreises,
- einen zweiten Schalter (S2) zum parallelen Verbinden des ersten Kondensators (C4) mit dem zweiten Kondensator (C5) des zweiten Resonanzkreises, und
- Steuermittel (4), das konfiguriert ist, um den ersten Schalter (S1) zu steuern, um die Kapazität des ersten Resonanzkreises und als ein Ergebnis die Schaltfrequenz des ersten Transistors zu ändern und den zweiten Schalter (S2) zu steuern, um die Kapazität des zweiten Resonanzkreises und als ein Ergebnis die Schaltfrequenz des zweiten Transistors (T2) zu ändern.

2. Betriebsvorrichtung nach Anspruch 1, wobei
jeder des ersten Resonanzkreises und des zweiten Resonanzkreises, eine Vielzahl von Kondensatoren (C6; C7) umfasst, die durch eine Vielzahl von Schaltern (S5; S6) parallel zueinander verbindbar sind, und
das Steuermittel (4) konfiguriert ist, um die Vielzahl von Schaltern (S5; S6) zu steuern, um die Kapazität des entsprechenden Resonanzkreises und als ein Ergebnis die Schaltfrequenz des mindestens einen Transistors (T1; T2) zu ändern.

3. Betriebsvorrichtung nach einem der vorstehenden Ansprüche, wobei Kapazitäten der Kondensatoren (C6; C7) unterschiedlich sind.

4. Betriebsvorrichtung nach einem der vorstehenden Ansprüche, wobei
der LLC-Resonanzwandler eine Vielzahl von Halbbrücken umfasst, wobei jede Halbbrücke den ersten Transistor (T1) und den zweiten Transistor (T2) umfasst und durch einen separaten Kondensator (C2a, C2b, C2c) mit dem LLC-Resonanzkreis verbunden ist.

5. Betriebsvorrichtung nach Anspruch 4, wobei
das Steuermittel (4) konfiguriert ist, um jeden Schalter (S1a.S1c, S2a.S2c) der Vielzahl von Halbbrücken zu steuern.

6. Betriebsvorrichtung nach einem der vorstehenden Ansprüche, wobei
der Spannungswandler konfiguriert ist, um eine Gleichspannung in eine Arbeitsspannung für das Leuchtmittel umzuwandeln.

7. Verfahren zum Steuern einer Betriebsvorrichtung für ein Leuchtmittel nach Anspruch 1, das Verfahren umfassend die Schritte von:
Erzeugen, durch den ersten Resonanzkreis der LC-Schaltung (3), des Steuersignals für den ersten Transistor (T1) und, durch den zweiten Resonanzkreis der LC-Schaltung (3), des Steuersignals für den zweiten Transistor (T2),
Steuern des ersten Schalters (S1), der den ersten Kondensator (C2) mit dem zweiten Kondensator (C3) des ersten Resonanzkreises parallel verbindet, um die Kapazität des ersten Resonanzkreises und als ein Ergebnis die Schaltfrequenz des ersten Transistors zu ändern, und
Steuern des zweiten Schalters (S2), der den ersten Kondensator (C4) mit dem zweiten Kondensator (C5) des zweiten Resonanzkreises parallel verbindet, um die Kapazität des zweiten Resonanzkreises und als ein Ergebnis die Schaltfrequenz des zweiten Transistors (T2) zu ändern.

## Revendications

1. Dispositif de commande pour un illuminant comprenant
un convertisseur résonant LLC incluant un circuit résonant LLC et au moins un demi-pont incluant un premier transistor (T1) et un deuxième transistor (T2), dans lequel chaque transistor est configuré pour être commandé par un signal de commande ;
et
un circuit LC (3) agencé pour générer le signal de commande, dans lequel le circuit LC (3) comprend un premier circuit résonant agencé pour générer le signal de commande pour le premier transistor (T1) et un deuxième circuit résonant agencé pour générer le signal de commande pour le deuxième transistor (T2), dans lequel chacun du premier circuit résonant et du deuxième circuit résonant comprend au moins une inductance (L2a, L2b), un premier condensateur (C2, C4) et un deuxième condensateur (C3, C5) et
le dispositif de commande comprend
- un premier commutateur (S1) pour connecter le premier condensateur (C2) en parallèle avec le deuxième condensateur (C3) du premier circuit résonnant,
- un deuxième commutateur (S2) pour connecter le premier condensateur (C4) en parallèle avec le deuxième condensateur (C5) du deuxième circuit résonnant et
- un moyen de commande (4) configuré pour commander le premier commutateur (S1) pour modifier la capacité du premier circuit résonnant et par conséquent la fréquence de commutation du premier transistor et pour commander le deuxième commutateur (S2) pour modifier la capacité du deuxième circuit résonnant et par conséquent la fréquence de commutation du deuxième transistor (T2).

2. Dispositif de commande selon la revendication 1, dans lequel
chacun du premier circuit résonant et du deuxième circuit résonant comprend une pluralité de condensateurs (C6 ; C7) pouvant être connectés en parallèle les uns aux autres par une pluralité de commutateurs (S5 ; S6) et
le moyen de commande (4) est configuré pour commander la pluralité de commutateurs (S5 ; S6) pour modifier la capacité du circuit résonnant correspondant et par conséquent la fréquence de commutation de l'au moins un transistor (T1 ; T2).

3. Dispositif de commande selon l'une quelconque des revendications précédentes, dans lequel
les capacités des condensateurs (C6 ; C7) sont différentes.

4. Dispositif de commande selon l'une quelconque des revendications précédentes, dans lequel
le convertisseur résonant LLC comprend une pluralité de demi-ponts, dans lequel chaque demi-pont comprend le premier transistor (T1) et le deuxième transistor (T2) et est connecté au circuit résonant LLC par un condensateur séparé (C2a, C2b, C2c).

5. Dispositif de commande selon la revendication 4, dans lequel
le moyen de commande (4) est configuré pour commander chaque commutateur (S1a..S1c, S2a..S2c) de la pluralité de demi-ponts.

6. Dispositif de commande selon l'une quelconque des revendications précédentes, dans lequel
le convertisseur de tension est configuré pour convertir une tension continue en une tension de fonctionnement pour l'illuminant.

7. Procédé de commande d'un dispositif de commande pour un illuminant selon la revendication 1, le procédé comprenant les étapes consistant à :
générer, par le premier circuit résonnant du circuit LC (3), le signal de commande pour le premier transistor (T1) et, par le deuxième circuit résonnant du circuit LC (3), le signal de commande pour le deuxième transistor (T2),
commander le premier commutateur (S1) connectant le premier condensateur (C2) en parallèle avec le deuxième condensateur (C3) du premier circuit résonnant pour modifier la capacité du premier circuit résonnant et par conséquent la fréquence de commutation du premier transistor et
commander le deuxième commutateur (S2) connectant le premier condensateur (C4) en parallèle avec le deuxième condensateur (C5) du deuxième circuit résonnant pour modifier la capacité du deuxième circuit résonnant et par conséquent pour modifier la fréquence de commutation du deuxième transistor (T2).
